(19) **Europäisches Patentamt**
**European Patent Office**
**Office européen des brevets**

(11) **EP 4 733 776 A1**

(12) **EUROPEAN PATENT APPLICATION**

(43) Date of publication:
**29.04.2026 Bulletin 2026/18**

(21) Application number: **25306699.7**

(22) Date of filing: **13.10.2025**

(51) International Patent Classification (IPC):
**G01R 1/20** (2006.01)    **G01R 31/52** (2020.01)
**H02H 1/00** (2006.01)    **H02H 3/08** (2006.01)
**H02H 3/04** (2006.01)    **H02H 7/00** (2006.01)

(52) Cooperative Patent Classification (CPC):
**H02H 3/08; G01R 31/52; H02H 1/0007;**
G01R 1/203; H02H 3/04; H02H 7/008

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **22.10.2024 CN 202422555281 U**

(71) Applicant: **SCHNEIDER ELECTRIC INDUSTRIES
SAS
92500 Rueil-Malmaison (FR)**

(72) Inventors:
• **ZHU, Qilei
Shanghai 201203 (CN)**
• **SHI, Ying
Shanghai 201203 (CN)**

• **ZHANG, Fenglian
Shanghai 201203 (CN)**
• **BI, Baoyun
Shanghai 201203 (CN)**
• **HUANG, Jie
Shanghai 201203 (CN)**
• **WU, Zuoren
Shanghai 201203 (CN)**
• **GUO, Yuchun
Shanghai 201203 (CN)**
• **WANG, Fangfang
Shanghai 201203 (CN)**

(74) Representative: **Manitz Finsterwald
Patent- und Rechtsanwaltspartnerschaft mbB
Martin-Greif-Straße 1
80336 München (DE)**

(54) **SHORT-CIRCUIT PROTECTION CIRCUIT**

(57)    Embodiments of the present disclosure provides a short-circuit protection circuit, including: a sampling resistor connected to a main loop, a parasitic inductance of the sampling resistor being adapted to generate an inductive signal based on a current in the main loop; a clamping circuit clamping a voltage of the inductive signal to a first threshold voltage to provide a clamping signal; a first compensation rectification circuit and a second compensation rectification circuit adapted to perform power factor compensation and rectification on the clamping signal to convert the clamping signal into an intermediate signal having a predetermined waveform; and an output circuit connected to the first compensation rectification circuit and the second compensation rectification circuit to receive the intermediate signal, and adapted to generate an output signal in response to a voltage of the intermediate signal being greater than a second threshold voltage to indicate that the main loop is short-circuited.

FIG. 1

EP 4 733 776 A1

## Description

## FIELD

Embodiments of the present disclosure relate to the field of electrical equipment, and more particularly, to a short-circuit protection circuit.

## BACKGROUND

In an AC power supply scenario or an inverted and rectified DC power supply scenario, when a short-circuit occurs, a direction of a short-circuit current is uncertain. A short-circuit current is usually converted into a voltage by using a precision resistor for signal processing, but no matter what kind of packaged precision resistor is, a lead inductance or a parasitic inductance inevitably exists, and when a surge or the short circuit occurs, a relatively large current flows through a sampling resistor, and instantaneous voltages generated by these parasitic inductances affect detection precision of circuit sampling, and even cause overvoltage damage to a component.

## SUMMARY

An object of the present disclosure is to provide a short-circuit protection circuit to at least partially solve the above problems.

In a first aspect of the present disclosure, there is provided a short-circuit protection circuit, including: a sampling resistor connected to a main loop to be protected, a parasitic inductance of the sampling resistor being adapted to generate an inductive signal based on a current in the main loop; a clamping circuit connected to two ends of the sampling resistor and configured to clamp a voltage of the inductive signal to a first threshold voltage to provide a clamping signal; a first compensation rectification circuit and a second compensation rectification circuit, the first compensation rectification circuit being connected to a first output end of the clamping circuit, the second compensation rectification circuit being connected to a second output end of the clamping circuit, the first compensation rectification circuit and the second compensation rectification circuit being adapted to perform power factor compensation and rectification on the clamping signal to convert the clamping signal into an intermediate signal having a predetermined waveform; and an output circuit connected to the first compensation rectification circuit and the second compensation rectification circuit to receive the intermediate signal, and adapted to generate, in response to a voltage of the intermediate signal being greater than a second threshold voltage, an output signal to indicate that the main loop is short-circuited, where the second threshold voltage is greater than the first threshold voltage.

According to embodiments of the present disclosure, the sampling resistor is adopted to detect a short-circuit current in the main loop in real time, then the clamping circuit is adopted to clamp the voltage of the inductive signal generated by the sampling resistor to the first threshold voltage to prevent overvoltage damage of a component, and then the first compensation rectification circuit and the second compensation rectification circuit are adopted to convert the clamping signal into the intermediate signal having the predetermined waveform, so that the output circuit is adopted to generate, in response to the voltage of the intermediate signal being greater than the second threshold voltage, the output signal to indicate that the main loop is short-circuited. The short-circuit current can be accurately detected, and components on a circuit can be reliably protected.

In some embodiments, the clamping circuit includes: a first resistor having a first end connected to a first end of the sampling resistor; a second resistor having a first end connected to a second end of the sampling resistor; a first capacitor having an end connected to the ground and another end connected to a second end of the first resistor; a second capacitor having an end connected to the ground and another end connected to a second end of the second resistor; a third capacitor having an end connected to a node between the first resistor and the first capacitor and another end connected to a node between the second resistor and the second capacitor; a first diode having an anode connected to the node between the first resistor and the first capacitor and a cathode connected to the node between the second resistor and the second capacitor; and a second diode having an anode connected to the node between the second resistor and the first diode and a cathode connected to a node between the first resistor and the first diode.

In some embodiments, the first compensation rectification circuit includes: a third resistor having a first end connected to the cathode of the second diode; a fourth resistor having a first end connected to the anode of the second diode; a first operational amplifier having a positive input end connected to a second end of the third resistor and a negative input end connected to a second end of the fourth resistor; a fifth resistor having a first end connected to a node between the first operational amplifier and the third resistor and a second end connected to the ground; a fourth capacitor connected in parallel with the fifth resistor; a third diode having an anode connected to a node between the first operational amplifier and the fourth resistor and a cathode connected to an output end of the first operational amplifier; a fourth diode having an anode connected to a node between the first operational amplifier and the third diode; a sixth resistor having a first end connected to a node between the fourth resistor and the third diode and a second end connected to a cathode of the fourth diode; and the fifth capacitor connected in parallel with the sixth resistor.

In some embodiments, the first compensation rectification circuit further includes: a seventh resistor having a first end connected to a node between the fourth diode and the sixth resistor; and a sixth capacitor having an end connected to a second end of the seventh resistor and another end connected to the ground.

In some embodiments, the second compensation rectification circuit includes: an eighth resistor having a first end connected to the anode of the second diode; a ninth resistor having a first end connected to the cathode of the second diode; a second operational amplifier having a positive input end connected to a second end of the eighth resistor and a negative input end connected to a second end of the ninth resistor; a tenth resistor having a first end connected to a node between the second operational amplifier and the eighth resistor and a second end connected to ground; a seventh capacitor connected in parallel with the tenth resistor; a fifth diode having an anode connected to a node between the second operational amplifier and the ninth resistor and a cathode connected to an output end of the second operational amplifier; a sixth diode having an anode connected to a node between the second operational amplifier and the fifth diode; an eleventh resistor having a first end connected to a node between the ninth resistor and the fifth diode and a second end connected to a cathode of the sixth diode; and an eighth capacitor connected in parallel with the eleventh resistor.

In some embodiments, the second compensation rectification circuit further includes: a twelfth resistor having a first end connected to a node between the sixth diode and the eleventh resistor; and a ninth capacitor having an end connected to a second end of the twelfth resistor and another end connected to the ground.

In some embodiments, the short-circuit protection circuit further includes a power supply to provide a power input to the first compensation rectification circuit, the second compensation rectification circuit, and the output circuit.

In some embodiments, the output circuit includes: a thirteenth resistor having a first end connected to the power supply; a fourteenth resistor having a first end connected to a second end of the thirteenth resistor and a second end connected to the ground; a first comparison circuit having a first input end connected to the first compensation rectification circuit and a second input end connected to a node between the thirteenth resistor and the fourteenth resistor; and a second comparison circuit having a first input end connected to the second compensation rectification circuit and a second input end connected to a node between the thirteenth resistor and the fourteenth resistor.

In some embodiments, the first comparison circuit includes: a third operational amplifier having a positive input end connected to the first compensation rectification circuit and a negative input end connected to the node between the thirteenth resistor and the fourteenth resistor; a seventh diode having an anode connected to an output end of the third operational amplifier; a fifteenth resistor having a first end connected to a cathode of the seventh diode and a second end connected to a node between the third operational amplifier and the first compensation rectification circuit; and an eighth diode having an anode connected to a node between the third operational amplifier and the seventh diode.

In some embodiments, the second comparison circuit includes: a fourth operational amplifier having a positive input end connected to the second compensation rectification circuit and a negative input end connected to the node between the thirteenth resistor and the fourteenth resistor; a ninth diode having an anode connected to an output end of the fourth operational amplifier; a sixteenth resistor having a first end connected to the cathode of the eighth diode and a second end connected to a node between the fourth operational amplifier and the second compensation rectification circuit; and a tenth diode having an anode connected to a node between the fourth operational amplifier and the ninth diode and a cathode connected to a cathode of the eighth diode.

In some embodiments, the output circuit further includes a seventeenth resistor having a first end connected to a node between the eighth diode and the tenth diode and a second end connected to the ground.

It should be understood that content described in this section is not intended to limit key features or important features of embodiments of the present disclosure, nor is it intended to limit the scope of the present disclosure. Other features of the present disclosure will be readily understood from following description.

## BRIEF DESCRIPTION OF DRAWINGS

The above and other features, advantages and aspects of embodiments of the present disclosure will become more apparent with reference to following detailed description taken in conjunction with drawings. In the drawings, the same or similar reference numerals denote the same or similar elements, where:

FIG. 1 illustrates a circuit diagram of a short-circuit protection circuit according to an embodiment of the present disclosure;

FIG. 2 illustrates a signal variation waveform diagram of a plurality of nodes in a short-circuit protection circuit under overvoltage protection according to an embodiment of the present disclosure;

FIG. 3 illustrates a signal variation waveform diagram of a plurality of nodes in a short-circuit protection circuit during a compensation rectification process according to an embodiment of the present disclosure; and

FIG. 4 illustrates a signal variation waveform diagram of a plurality of nodes in a short-circuit protection circuit under short-circuit protection according to an embodiment of the present disclosure.

## DETAILED DESCRIPTION

Embodiments of the present disclosure will be described in more detail below with reference to drawings. Although the embodiments of the present disclosure are shown in the drawings, it should be understood that the present disclosure may be implemented in various forms and should not be limited by the embodiments set forth herein. Rather, these embodiments are provided to make the present disclosure more thorough and complete, and can fully convey the scope of the present disclosure to those skilled in the art.

As used herein, the term "include" and variations thereof means open inclusive, i.e., "include but not limited to". Unless specifically stated, the term "or" means "and/or". The term "based on" means "based at least in part on". The terms "an example embodiment" and "an embodiment" mean "at least one example embodiment". The term "another embodiment" means "at least one further embodiment". The terms "first," "second," and the like may refer to different or identical objects.

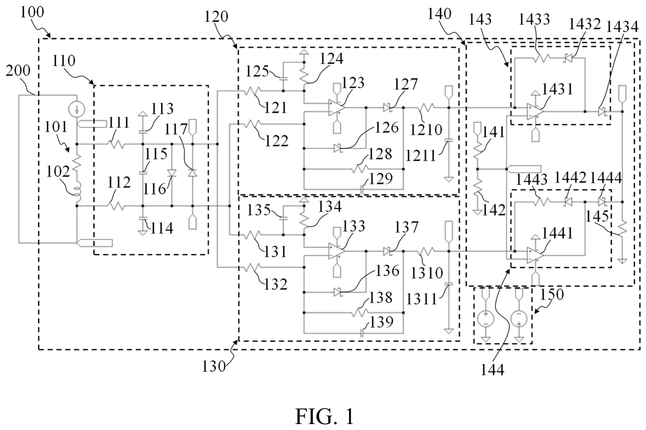

As described above, in an AC power supply scenario or an inverted and rectified DC power supply scenario, when a short-circuit occurs, a direction of a short-circuit current is uncertain. A short-circuit current is usually converted into a voltage by using a precision resistor for signal processing, but no matter what kind of packaged precision resistor is, a lead inductance or a parasitic inductance inevitably exists, and when a surge or the short circuit occurs, a relatively large current flows through a sampling resistor, and instantaneous voltages generated by these parasitic inductances affect detection precision of circuit sampling, and even cause overvoltage damage to a component. Hereinafter, a principle of the present disclosure will be described with reference to FIGS. 1 to 4.

FIG. 1 illustrates a circuit diagram of a short-circuit protection circuit 100 according to an embodiment of the present disclosure. As shown in FIG. 1, the short-circuit protection circuit 100 generally includes a sampling resistor 101, a clamping circuit 110, a first compensation rectification circuit 120, a second compensation rectification circuit 130, and an output circuit 140. The sampling resistor 101 is connected to a main loop 200 to be protected. A parasitic inductance 102 of the sampling resistor 101 is adapted to generate an inductive signal based on a current in the main loop 200.

The clamping circuit 110 is connected to two ends of the sampling resistor 101 and configured to clamp a voltage of the inductive signal to a first threshold voltage to provide a clamping signal. The first compensation rectification circuit 120 and the second compensation rectification circuit 130 are respectively connected to a first output end and a second output end of the clamping circuit. The first compensation rectification circuit 120 and the second compensation rectification circuit 130 are adapted to perform power factor compensation and rectification on the clamping signal to convert the clamping signal into an intermediate signal having a predetermined waveform. The output circuit 140 is connected to the first compensation rectification circuit 120 and the second compensation rectification circuit 130 to receive the intermediate signal, and is adapted to generate, in response to a voltage of the intermediate signal being greater than a second threshold voltage, an output signal to indicate that the main loop is short-circuited.

In an embodiment, the main loop 200 may include a MOS transistor for short-circuit protection. For example, assuming that a turn-off threshold of the short-circuit current is 1000 amps (A) and turn-off time of the MOS transistor is 100 nanoseconds (ns), then change rate di/dt of the current over time when the MOS transistor is turned off is 10A/ns. Assuming that the resistance of the sampling resistor 101 is 250 microohms ($\mu\Omega$) and the parasitic inductance 102 of the sampling resistor 101 is 1 nanohenry (nH), the voltage of the inductive signal may be calculated by the following formula:

$$Vlr = Lr * di/dt = 1nH * 10A/ns = 10V$$

where Vlr represents the voltage of the inductive signal and Lr represents the parasitic inductance 102.

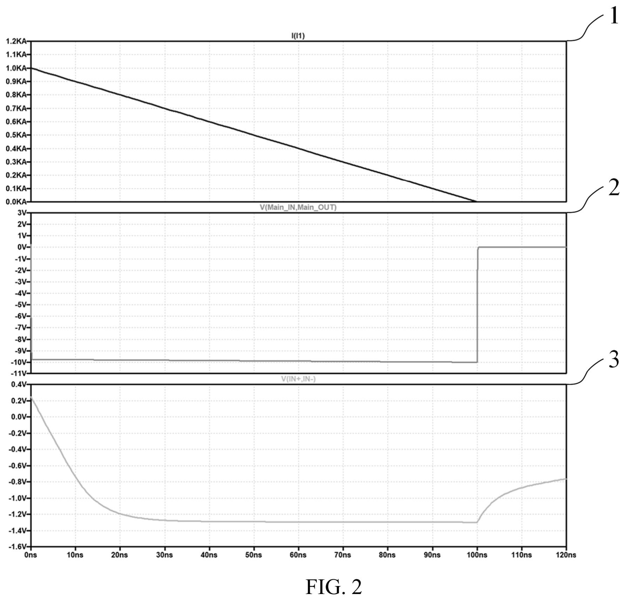

FIG. 2 illustrates a signal variation waveform diagram of a plurality of nodes in the short-circuit protection circuit 100 under overvoltage protection according to an embodiment of the present disclosure. Chart 1 illustrates a short-circuit current change diagram of the main loop 200 according to an embodiment of the present disclosure, chart 2 illustrates a voltage change diagram of the inductive signal according to an embodiment of the present disclosure, and chart 3 illustrates a voltage change diagram of the clamping signal according to an embodiment of the present disclosure.

As shown in chart 1 and chart 2 in FIG. 2, a large short-circuit current may cause a large instantaneous voltage to be generated by the parasitic inductance 102 of the sampling resistor 101, which may easily affect detection accuracy of the short-circuit current and cause damage to electronic components. Therefore, the voltage of the inductive signal needs to be limited by the clamping circuit 110 to perform overvoltage protection on the electronic component.

In an embodiment, as shown in FIG. 1, the clamping circuit 110 includes a first resistor 111, a second resistor 112, a first capacitor 113, a second capacitor 114, a third capacitor 115, a first diode 116, and a second diode 117. A first end of the first resistor 111 is connected to a first end of the sampling resistor 101. A first end of the second resistor 112 is connected to a second end of the sampling resistor 101. The first resistor 111 and the second resistor 112 can limit a current of the inductive signal to reduce energy of the inductive signal as much as possible.

With continued reference to FIG. 1, an end of the first capacitor 113 is connected to ground and another end is connected to a second end of the first resistor 111. An end of the second capacitor 114 is connected to the ground and another end is connected to a second end of the second resistor 112. An end of the third capacitor 115 is connected to a node between the first resistor 111 and the first capacitor 113, and another end is connected to a node between the second resistor 112 and the second capacitor 114.

In an embodiment, the first capacitor 113 and the second capacitor 114 may use a common-mode capacitor, and the third capacitor 115 may use a differential-mode capacitor to filter the inductive signal. It should be understood that, based on teachings given in the present disclosure, those skilled in the art may envisage using other components to implement the above filtering function, and these implementations all fall within the scope of the present disclosure.

With continued reference to FIG. 1, an anode of the first diode 116 is connected to a node between the first resistor 111 and the first capacitor 113 and a cathode is connected to the node between the second resistor 112 and the second capacitor 114. An anode of the second diode 117 is connected to a node between the second resistor 112 and the first diode 116 and a cathode is connected to a node between the first resistor 111 and the first diode 116.

As shown in chart 3 in FIG. 2, a forward voltage drop of the diode is used for clamping protection, so that the voltage of the inductive signal may be clamped to the first threshold voltage (for example, -1.2V or 1.2V) to provide a clamping signal with a lower voltage amplitude, thereby preventing the voltage of the inductive signal from damaging electronic components.

In an embodiment, as shown in FIG. 1, the first compensation rectification circuit 120 includes a third resistor 121, a fourth resistor 122, a fifth resistor 124, a fourth capacitor 125, a third diode 126, a fourth diode 127, a sixth resistor 128, a fifth capacitor 129, a seventh resistor 1210, and a sixth capacitor 1211. A first end of the third resistor 121 is connected to the cathode of the second diode 117. A first end of the fourth resistor 122 is connected to the anode of the second diode 117. The third resistor 121 and the fourth resistor 122 can limit the current of the clamping signal.

A positive input end of the first operational amplifier 123 is connected to the second end of the third resistor 121 and a negative input end is connected to the second end of the fourth resistor 122. A first end of the fifth resistor 124 is connected to a node between the first operational amplifier 123 and the third resistor 121 and a second end thereof is connected to the ground. The fourth capacitor 125 and the fifth resistor 124 are connected in parallel. An anode of the third diode 126 is connected to a node between the first operational amplifier 123 and the fourth resistor 122 and a cathode thereof is connected to an output end of the first operational amplifier 123. An anode of the fourth diode 127 is connected to a node between the first operational amplifier 123 and the third diode 126. A first end of the sixth resistor 128 is connected to a node between the fourth resistor 122 and the third diode 126 and a second end thereof is connected to a cathode of the fourth diode 127. The fifth capacitor 129 and the sixth resistor 128 are connected in parallel.

In an embodiment, the fourth capacitor 125 and the fifth capacitor 129 can perform power factor compensation on the clamping signal. For example, the fourth capacitor 125 and the fifth capacitor 129 may use the same capacitor, denoted as C1. The fifth resistor 124 and the sixth resistor 128 may have the same resistance value, denoted as R1. Assuming that the resistance of the sampling resistor is Rsamp, capacitances of the fourth capacitor 125 and the fifth capacitor 129 may be determined by the following formula:

$$C1 = Lr/(Rsamp/R1)$$

With continued reference to FIG. 1, a first end of the seventh resistor 1210 is connected to a node between the fourth diode 127 and the sixth resistor 128. An end of the sixth capacitor 1211 is connected to a second end of the seventh resistor 1210 and another end is connected to the ground. Further filtering processing may be performed on the clamping signal by using a filter circuit formed by the seventh resistor 1210 and the sixth capacitor 1211.

In an embodiment, as shown in FIG. 1, the second compensation rectifying circuit 130 includes an eighth resistor 131, a ninth resistor 132, a second operational amplifier 133, a tenth resistor 134, a seventh capacitor, a fifth diode 136, a sixth diode 137, an eleventh resistor 138, an eighth capacitor 139, a twelfth resistor 1310, and a ninth capacitor 1311. A first end of the eighth resistor 131 is connected to the anode of the second diode 117. A first end of the ninth resistor 132 is connected to the cathode of the second diode 117. The eighth resistor 131 and the ninth resistor 132 can limit the current of the clamping signal.

A positive input end of the second operational amplifier 133 is connected to a second end of the eighth resistor 131 and a negative input end of the second operational amplifier 133 is connected to the second end of the ninth resistor 132. A first end of the tenth resistor 134 is connected to a node between the second operational amplifier 133 and the eighth resistor 131 and a second end thereof is connected to the ground. The seventh capacitor 135 and the tenth resistor 134 are connected in parallel. An anode of the fifth diode 136 is connected to a node between the second operational amplifier 133 and the ninth resistor 132 and a cathode thereof is connected to an output end of the second operational amplifier 133. An anode of the sixth diode 137 is connected to a node between the second operational amplifier 133 and the fifth diode 136. A first end of the eleventh resistor 138 is connected to a node between the ninth resistor 132 and the fifth diode 136 and a second end thereof is connected to a cathode of the sixth diode 137. The eighth capacitor 139 and the eleventh resistor 138 are connected in parallel.

In an embodiment, the seventh capacitor 135 and the eighth capacitor 139 can perform power factor compensation on the clamping signal. For example, the seventh capacitor 135 and the eighth capacitor 139 may use the same capacitor, denoted as C2. The tenth resistor 134 and the eleventh resistor 138 may have the same resistance value, denoted as R2. Assuming that the resistance of the sampling resistor is Rsamp, capacitances of the fourth capacitor 125 and the fifth capacitor 129 may be determined by the following formula:

$$C2 = Lr/(Rsamp/R2)$$

In an embodiment, capacitances of the fourth capacitor 125, the fifth capacitor 129, the seventh capacitor 135, and the eighth capacitor 139 may be the same. Resistance values of the fifth resistor 124, the sixth resistor 128, the tenth resistor 134, and the eleventh resistor 138 may be the same. It should be understood that values of the capacitors and the resistors may be determined according to actual working requirements, which is not limited in the present disclosure.

With continued reference to FIG. 1, a first end of the twelfth resistor 1310 is connected to a node between the sixth diode 137 and the eleventh resistor 138. An end of the ninth capacitor 1311 is connected to a second end of the twelfth resistor 1310 and another end thereof is connected to the ground. Further filtering processing may be performed on the clamping signal by using a filtering circuit including the twelfth resistor 1310 and the ninth capacitor 1311.

In an embodiment, the short-circuit protection circuit 100 further includes a power supply 150 to provide a power input to the first compensation rectification circuit 120, the second compensation rectification circuit 130, and the output circuit 140. The power supply 150 may be, for example, an AC power supply.

In an embodiment, the first operational amplifier 123 and the second operational amplifier 133 may be, for example, operational amplifiers powered by dual power supplies. An operational amplifier circuit composed of the first operational amplifier 123 and the second operational amplifier 133 can perform precise rectification on the clamping signal to convert a short-circuit waveform of positive and negative power supplies into a rectified waveform of a single power supply, thereby generating the intermediate signal.

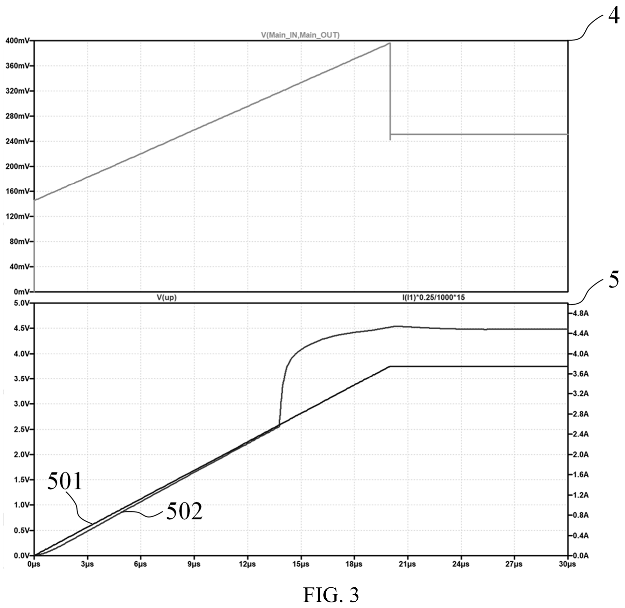

FIG. 3 illustrates a signal variation waveform diagram of a plurality of nodes in the short-circuit protection circuit 100 during a compensation rectification process according to an embodiment of the present disclosure. Chart 4 illustrates a voltage variation diagram of two ends of the sampling resistor 101 according to an embodiment of the present disclosure, and chart 5 illustrates a current variation diagram of the short-circuit current and a voltage variation diagram of the intermediate signal according to an embodiment of the present disclosure.

In an embodiment, as shown in chart 4 in FIG. 3, at a starting position, due to presence of the parasitic inductance 102, a voltage of two ends of the sampling resistor 101 is raised, i.e., an error introduced by the parasitic inductance. Therefore, reactive compensation needs to be performed on a sampled signal by using each capacitor in the first compensation rectification circuit 120 and the second compensation rectification circuit 130, to obtain a more accurate sampled signal.

In an embodiment, as shown in chart 5 of FIG. 3, a curve 501 represents a change curve of the short-circuit current, and a curve 502 represents a change curve of a compensated and rectified intermediate signal. It is seen that the curve of the intermediate signal processed by the first compensation rectification circuit 120 and the second compensation rectification circuit 130 substantially matches the curve of the short-circuit current within a certain time. A bending part of the curve 502 represents a threshold point of the short-circuit trigger, and when it is detected that the short-circuit current reaches a preset threshold, the curve 502 will be pulled up by the output circuit 140 connected to a rear end. A working principle of the output circuit 140 will be described in detail below.

Referring back to FIG. 1, in an embodiment, the output circuit 140 includes a thirteenth resistor 141, a fourteenth resistor 142, a first comparison circuit 143, and a second comparison circuit 144. A first end of the thirteenth resistor 141 is connected to the power supply 150. A first end of the fourteenth resistor 142 is connected to a second end of the thirteenth resistor 141 and a second end thereof is connected to the ground. A first input end of the first comparison circuit 143 is connected to the first compensation rectification circuit 120 and a second input end thereof is connected to a node between the thirteenth resistor 141 and the fourteenth resistor 142. A first input end of the second comparison circuit 144 is connected to the second compensation rectification circuit 130 and a second input end thereof is connected to a node between the thirteenth resistor 141 and the fourteenth resistor 142. In an embodiment, resistance values of the thirteenth resistor 141 and the fourteenth resistor 142 may be determined according to a required short-circuit trigger threshold.

In an embodiment, the first comparison circuit 143 includes a third operational amplifier 1431, a seventh diode 1432, a fifteenth resistor 1433, and an eighth diode 1434. A positive input end of the third operational amplifier 1431 is connected to the first compensation rectification circuit 120 and a negative input end thereof is connected to a node between the thirteenth resistor 141 and the fourteenth resistor 142. An anode of the seventh diode 1432 is connected to the output end of the third operational amplifier 1431. The fifteenth resistor 1433 has a first end connected to a cathode of the seventh diode 1432 and a second end connected to a node between the third operational amplifier 1431 and the first compensation rectification circuit 120. An anode of the eighth diode 1434 is connected to a node between the third operational amplifier 1431 and the seventh diode 1432.

In an embodiment, the second comparison circuit 144 includes a fourth operational amplifier 1441, a ninth diode 1442, a sixteenth resistor 1443, and a tenth diode 1444. A positive input end of the fourth operational amplifier 1441 is connected to the second compensation rectification circuit 130 and a negative input end thereof is connected to a node between the thirteenth resistor 141 and the fourteenth resistor 142. An anode of the ninth diode 1442 is connected to an output end of the fourth operational amplifier 1441. A first end of the sixteenth resistor 1443 is connected to a cathode of the eighth diode 1442 and a second end thereof is connected to a node between the fourth operational amplifier 1441 and the second compensation rectification circuit 130. An anode of the tenth diode 1444 is connected to a node between the fourth operational amplifier 1441 and the ninth diode 1442 and a cathode thereof is connected to a cathode of the eighth diode 1434.

In an embodiment, negative input ends of the third operational amplifier 1431 and the fourth operational amplifier 1441 can receive a voltage of a line where the thirteenth resistor 141 and the fourteenth resistor 142 are located, and use the voltage as a reference voltage. Positive input ends of the third operational amplifier 1431 and the fourth operational amplifier 1441 can receive the intermediate signal to compare the voltage of the intermediate signal with the reference voltage. The reference voltage may be equivalent to the second threshold voltage (e.g., 2.5V).

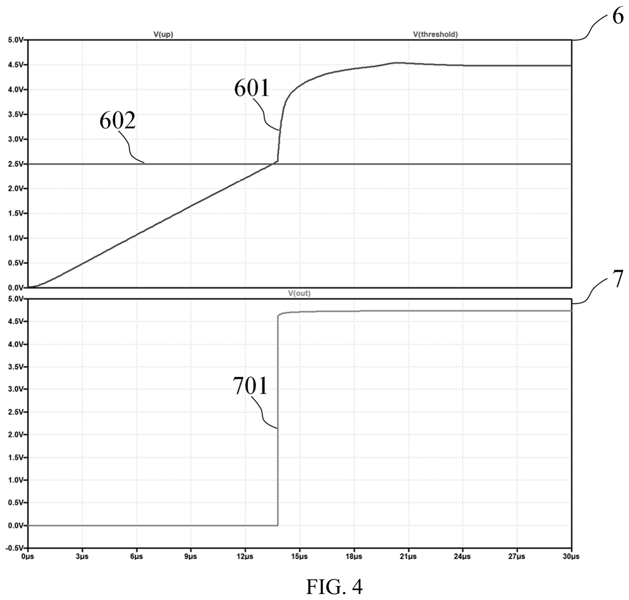

FIG. 4 illustrates a signal variation waveform diagram of a plurality of nodes in the short-circuit protection circuit 100 under short-circuit protection according to an embodiment of the present disclosure. Chart 6 illustrates a voltage variation diagram of an intermediate signal and a second threshold voltage according to an embodiment of the present disclosure, and chart 7 illustrates a voltage variation diagram of an output signal according to an embodiment of the present disclosure.

In an embodiment, as shown by chart 6 in FIG. 4, a curve 601 represents a variation curve of the intermediate signal, and a straight line 602 represents a horizontal line of the second threshold voltage. As can be seen, a curve 502 will be pulled high when curve 601 begins to bend as it passes through the straight line 602, indicating that a threshold point for short-circuit triggering is reached.

In an embodiment, as shown in chart 7 of FIG. 4, when the voltage of the intermediate signal is greater than the second threshold voltage, the first comparison circuit 143 or the second comparison circuit 144 will generate an output signal having a certain voltage amplitude. Otherwise, as shown in first half of curve 701, the output end of the first comparison circuit 143 or the second comparison circuit 144 is zero, and the short-circuit protection circuit 100 is in a standby state.

In an embodiment, the first comparison circuit 143 and the second comparison circuit 144 may adopt positive feedback latching. It should be noted that, it is necessary to ensure that a comparison voltage of positive feedback is always greater than the reference voltage, otherwise, when the current is reversed, outputs of the first comparison circuit 143 and the second comparison circuit 144 will be unlocked.

Taking the first comparison circuit 143 as an example, assuming that resistance values of the first resistor 111, the fourth resistor 122, the sixth resistor 128, the seventh resistor 1210, the fifteenth resistor 1433, the thirteen resistor 141, and the fourteenth resistor 142 are R111, R122, R128, R1210, R1433, R141, and R142, respectively, it is necessary to ensure that $R1433/(R111 + R122 + R128 + R1210) > R141/R142$. The second comparison circuit 144 is similar, and details are not described herein again.

In an embodiment, the output circuit 140 further includes a seventeenth resistor 145. A first end of the seventeenth resistor 145 is connected to a node between the eighth diode 1434 and the tenth diode 1444 and a second end thereof is connected to the ground to provide a stable output signal.

By adopting the output circuit composed of two comparison circuits, the signal can be latched and then output after the short circuit is detected to indicate that the main loop 200 is short-circuited. In an embodiment, the output signal may be used as an input of a component such as a driving chip, so that the driving circuit is turned off in time. It may also serve as an input signal to an indicator light to indicate that the main loop 200 needs to be turned off. It should be understood that, based on the teachings given in the present disclosure, other components that may occur to those skilled in the art implement the above functions, and these implementations all fall within the scope of the present disclosure.

Embodiments of the present disclosure have been described above, and the above description is exemplary, not exhaustive, and is not limited to the disclosed embodiments. Many modifications and variations will be apparent to those of ordinary skill in the art without departing from the scope and spirit of the illustrated embodiments. The selection of terms as used herein is intended to best explain principles of embodiments, practical application or technical improvements to the market, or to enable others of ordinary skill in the art to understand the embodiments disclosed herein.

**Claims**

1. A short-circuit protection circuit (100), **characterized by** comprising:

a sampling resistor (101) connected to a main loop (200) to be protected, a parasitic inductance (102) of the sampling resistor (101) being adapted to generate an inductive signal based on a current in the main loop (200); a clamping circuit (110) connected to two ends of the sampling resistor (101) and configured to clamp a voltage of the inductive signal to a first threshold voltage to provide a clamping signal; a first compensation rectification circuit (120) and a second compensation rectification circuit (130), the first compensation rectification circuit (120) being connected to a first output end of the clamping circuit (110), the second compensation rectification circuit (130) being connected to a second output end of the clamping circuit (110), the first compensation rectification circuit (120) and the second compensation rectification circuit (130) being adapted to perform power factor compensation and rectification on the clamping signal to convert the clamping signal into an intermediate signal having a predetermined waveform; and an output circuit (140) connected to the first compensation rectification circuit (120) and the second compensation rectification circuit (130) to receive the intermediate signal, and adapted to generate, in response to a voltage of the intermediate signal being greater than a second threshold voltage, an output signal to indicate that the main loop (200) is short-circuited, wherein the second threshold voltage is greater than the first threshold voltage.

2. The short-circuit protection circuit (100) according to claim 1, **characterized in that** the clamping circuit (110) comprises:

a first resistor (111) having a first end connected to a first end of the sampling resistor (101);
a second resistor (112) having a first end connected to a second end of the sampling resistor (101);
a first capacitor (113) having an end connected to ground and another end connected to a second end of the first resistor (111);
a second capacitor (114) having an end connected to the ground and another end connected to a second end of the second resistor (112);
a third capacitor (115) having an end connected to a node between the first resistor (111) and the first capacitor (113) and another end connected to a node between the second resistor (112) and the second capacitor (114);
a first diode (116) having an anode connected to the node between the first resistor (111) and the first capacitor (113) and a cathode connected to the node between the second resistor (112) and the second capacitor (114); and
a second diode (117) having an anode connected to the node between the second resistor (112) and the first diode (116) and a cathode connected to a node between the first resistor (111) and the first diode (116).

3. The short-circuit protection circuit (100) according to claim 2, **characterized in that** the first compensation rectification circuit (120) comprises:

a third resistor (121) having a first end connected to the cathode of the second diode (117);
a fourth resistor (122) having a first end connected to the anode of the second diode (117);
a first operational amplifier (123) having a positive input end connected to a second end of the third resistor (121) and a negative input end connected to a second end of the fourth resistor (122);
a fifth resistor (124) having a first end connected to a node between the first operational amplifier (123) and the third resistor (121) and a second end connected to the ground;
a fourth capacitor (125) connected in parallel with the fifth resistor (124);
a third diode (126) having an anode connected to a node between the first operational amplifier (123) and the fourth resistor (122) and a cathode connected to an output end of the first operational amplifier (123);
a fourth diode (127) having an anode connected to a node between the first operational amplifier (123) and the third diode (126);
a sixth resistor (128) having a first end connected to a node between the fourth resistor (122) and the third diode (126) and a second end connected to a cathode of the fourth diode (127); and
a fifth capacitor (129) connected in parallel with the sixth resistor (128).

4. The short-circuit protection circuit (100) according to claim 3, **characterized in that** the first compensation rectification circuit (120) further comprises:

a seventh resistor (1210) having a first end connected to a node between the fourth diode (127) and the sixth resistor (128);
a sixth capacitor (1211) having an end connected to a second end of the seventh resistor (1210) and another end connected to the ground.

5. The short-circuit protection circuit (100) according to any of claims 2-4, **characterized in that** the second compensation rectification circuit (130) comprises:

an eighth resistor (131) having a first end connected to the anode of the second diode (117);
a ninth resistor (132) having a first end connected to the cathode of the second diode (117);
a second operational amplifier (133) having a positive input end connected to a second end of the eighth resistor (131) and a negative input end connected to a second end of the ninth resistor (132);
a tenth resistor (134) having a first end connected to a node between the second operational amplifier (133) and the eighth resistor (131) and a second end connected to the ground;
a seventh capacitor (135) connected in parallel with the tenth resistor (134);
a fifth diode (136) having an anode connected to a node between the second operational amplifier (133) and the ninth resistor (132) and a cathode connected to an output end of the second operational amplifier (133);
a sixth diode (137) having an anode connected to a node between the second operational amplifier (133) and the fifth diode (136);
an eleventh resistor (138) having a first end connected to a node between the ninth resistor (132) and the fifth diode (136) and a second end connected to a cathode of the sixth diode (137); and
an eighth capacitor (139) connected in parallel with the eleventh resistor (138).

6.  The short-circuit protection circuit (100) according to claim 5, **characterized in that** the second compensation rectification circuit (130) further comprises:

    a twelfth resistor (1310) having a first end connected to a node between the sixth diode (137) and the eleventh resistor (138);
    a ninth capacitor (1311) having an end connected to a second end of the twelfth resistor (1310) and another end connected to the ground.

7.  The short-circuit protection circuit (100) according to any of claims 1-6, **characterized in that** the short-circuit protection circuit (100) further comprises a power supply (150) to provide a power input to the first compensation rectification circuit (120), the second compensation rectification circuit (130) and the output circuit (140).

8.  The short-circuit protection circuit (100) according to claim 7, **characterized in that** the output circuit (140) comprises:

    a thirteenth resistor (141) having a first end connected to the power supply (150);

a fourteenth resistor (142) having a first end connected to a second end of the thirteenth resistor (141) and a second end connected to the ground;
a first comparison circuit (143) having a first input end connected to the first compensation rectification circuit (120) and a second input end connected to a node between the thirteenth resistor (141) and the fourteenth resistor (142); and
a second comparison circuit (144) having a first input end connected to the second compensation rectification circuit (130) and a second input end connected to the node between the thirteenth resistor (141) and the fourteenth resistor (142).

9.  The short-circuit protection circuit (100) according to claim 8, **characterized in that** the first comparison circuit (143) comprises:

    a third operational amplifier (1431) having a positive input end connected to the first compensation rectification circuit (120) and a negative input end connected to the node between the thirteenth resistor (141) and the fourteenth resistor (142);
    a seventh diode (1432) having an anode connected to an output end of the third operational amplifier (1431);
    a fifteenth resistor (1433) having a first end connected to a cathode of the seventh diode (1432) and a second end connected to a node between the third operational amplifier (1431) and the first compensation rectification circuit (120); and
    an eighth diode (1434) having an anode connected to a node between the third operational amplifier (1431) and the seventh diode (1432).

10.  The short-circuit protection circuit (100) according to claim 9, **characterized in that** the second comparison circuit (144) comprises:

    a fourth operational amplifier (1441) having a positive input end connected to the second compensation rectification circuit (130) and a negative input end connected to the node between the thirteenth resistor (141) and the fourteenth resistor (142);
    a ninth diode (1442) having an anode connected to an output end of the fourth operational amplifier (1441);
    a sixteenth resistor (1443) having a first end connected to the cathode of the eighth diode (1442) and a second end connected to a node between the fourth operational amplifier (1441) and the second compensation rectification circuit (130); and
a tenth diode (1444) having an anode connected to a node between the fourth operational amplifier (1441) and the ninth diode (1442) and a cathode connected to a cathode of the eighth diode (1434).

11. The short-circuit protection circuit (100) according to claim 10, **characterized in that** the output circuit (140) further comprises a seventeenth resistor (145) having a first end connected to a node between the eighth diode (1434) and the tenth diode (1444) and a second end connected to the ground.

FIG. 1

FIG. 2

FIG. 3

FIG. 4

**EUROPEAN SEARCH REPORT**

Application Number

EP 25 30 6699

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 5 900 714 A (DUBHASHI AJIT [US] ET AL) 4 May 1999 (1999-05-04) <br> * figure 3 * <br> * figure 4 * <br> * column 1, line 52 - line 56 * <br> * column 3, line 1 - line 4 * <br> * column 3, line 5 - line 18 * <br> ----- | 1-11 | INV. <br> G01R1/20 <br> G01R31/52 <br> H02H1/00 <br> H02H3/08 <br><br> ADD. <br> H02H3/04 |
| A | EP 3 771 055 B1 (NEXTER SYSTEMS [FR]) 5 April 2023 (2023-04-05) <br> * figure 3 * <br> * paragraph [0010] - paragraph [0012] * <br> * paragraph [0014] * <br> ----- | 1-11 | H02H7/00 |
| A | US 11 099 216 B2 (KONGSBERG INC [CA]) 24 August 2021 (2021-08-24) <br> * figure 1 * <br> * figure 2 * <br> * figure 5 * <br> * column 1, line 34 - line 52 * <br> * column 7, line 15 - line 18 * <br> ----- | 1-11 | |
| | | | TECHNICAL FIELDS SEARCHED (IPC) |
| A | EP 4 131 692 B1 (FUTURE SYSTEMS BESITZ GMBH [DE]) 15 November 2023 (2023-11-15) <br> * figure 2 * <br> * paragraph [0041] * <br> * paragraph [0054] * <br> ----- | 1-11 | H02H <br> G01R |

The present search report has been drawn up for all claims

| Place of search | Date of completion of the search | Examiner |
|---|---|---|
| Munich | 27 January 2026 | Falagan de la Sierra |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
........................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 30 6699

This annex lists the patent family members relating to the patent documents cited in the above-mentioned European search report.
The members are as contained in the European Patent Office EDP file on
The European Patent Office is in no way liable for these particulars which are merely given for the purpose of information.

27-01-2026

| Patent document cited in search report | | Publication date | Patent family member(s) | | Publication date |
|---|---|---|---|---|---|
| US 5900714 | A | 04-05-1999 | DE | 19749392 A1 | 20-05-1998 |
| | | | FR | 2755766 A1 | 15-05-1998 |
| | | | GB | 2320762 A | 01-07-1998 |
| | | | IT | 1296074 B1 | 09-06-1999 |
| | | | JP | 3202672 B2 | 27-08-2001 |
| | | | JP | H10191683 A | 21-07-1998 |
| | | | KR | 19980042226 A | 17-08-1998 |
| | | | SG | 60147 A1 | 22-02-1999 |
| | | | TW | 413733 B | 01-12-2000 |
| | | | US | 5900714 A | 04-05-1999 |
| EP 3771055 | B1 | 05-04-2023 | EP | 3771055 A1 | 27-01-2021 |
| | | | FR | 3099250 A1 | 29-01-2021 |
| US 11099216 | B2 | 24-08-2021 | EP | 3423841 A1 | 09-01-2019 |
| | | | US | 2019339304 A1 | 07-11-2019 |
| | | | WO | 2017149359 A1 | 08-09-2017 |
| EP 4131692 | B1 | 15-11-2023 | CN | 117795803 A | 29-03-2024 |
| | | | EP | 4131692 A1 | 08-02-2023 |
| | | | ES | 2967058 T3 | 25-04-2024 |
| | | | PL | 4131692 T3 | 26-02-2024 |
| | | | US | 2024175939 A1 | 30-05-2024 |
| | | | WO | 2023012361 A1 | 09-02-2023 |

EPO FORM P0459